(19) Europäisches Patentamt
European Patent Office
Office européen des brevets

(11) **EP 3 465 348 B1**

(12) **EUROPÄISCHE PATENTSCHRIFT**

(45) Veröffentlichungstag und Bekanntmachung des Hinweises auf die Patenterteilung:
**24.11.2021  Patentblatt 2021/47**

(21) Anmeldenummer: **17725602.1**

(22) Anmeldetag: **24.05.2017**

(51) Int Cl.:
*G03F 7/20* (2006.01)       *G02B 5/08* (2006.01)
*G21K 1/06* (2006.01)       *G02B 5/18* (2006.01)

(86) Internationale Anmeldenummer:
**PCT/EP2017/062639**

(87) Internationale Veröffentlichungsnummer:
**WO 2017/207401 (07.12.2017 Gazette 2017/49)**

(54) **EUV-KOLLEKTOR**

EUV COLLECTOR

COLLECTEUR EUV

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **31.05.2016  DE 102016209359**

(43) Veröffentlichungstag der Anmeldung:
**10.04.2019  Patentblatt 2019/15**

(73) Patentinhaber: **Carl Zeiss SMT GmbH**
**73447 Oberkochen (DE)**

(72) Erfinder:
• **SCHUSTER, Ingrid**
  **73447 Oberkochen (DE)**
• **MERKEL, Wolfgang**
  **89231 Neu-Ulm (DE)**
• **METALIDIS, Georgo**
  **89551 Königsbronn-Zang (DE)**
• **KIEREY, Holger**
  **73434 Aalen (DE)**

(74) Vertreter: **Rau, Schneck & Hübner**
**Patentanwälte Rechtsanwälte PartGmbB**
**Königstraße 2**
**90402 Nürnberg (DE)**

(56) Entgegenhaltungen:
**DE-A1-102006 022 352     DE-A1-102009 044 462**

• **BOZEC X ET AL: "Cooled EUV collector optics for LPP and DPP sources", EXTREME ULTRAVIOLET (EUV) LITHOGRAPHY II, SPIE, 1000 20TH ST. BELLINGHAM WA 98225-6705 USA, Bd. 7969, Nr. 1, 17. März 2011 (2011-03-17), Seiten 1-10, XP060009093, DOI: 10.1117/12.876981 [gefunden am 2011-03-29]**
• **GIRARD LUC ET AL: "Fabrication of EUVL micro-field exposure tools with 0.5 NA", OPTOMECHATRONIC MICRO/NANO DEVICES AND COMPONENTS III : 8 - 10 OCTOBER 2007, LAUSANNE, SWITZERLAND; [PROCEEDINGS OF SPIE , ISSN 0277-786X], SPIE, BELLINGHAM, WASH, Bd. 9633, 11. Oktober 2015 (2015-10-11), Seiten 96330V-96330V, XP060062765, DOI: 10.1117/12.2203138 ISBN: 978-1-62841-730-2**

EP 3 465 348 B1

**Beschreibung**

Die Erfindung betrifft einen EUV-Kollektor zum Einsatz in einer EUV-Projektionsbelichtungsanlage.

Eine Beleuchtungsoptik mit einem derartigen Kollektor ist bekannt aus der DE 10 2013 002 064 A1.

Der Fachartikel "Cooled EUV collector optics for LPP and DPP sources" von X. Bozec et al., EXTREME ULTRAVIOLET (EUV) LITHOGRAPHY II, SPIE, 100020 TH ST. BELLINGHAM WA 98225-6705 ──USA, Bd. 7969, Nr. 1, 17. März 2011 (2011-03-17), Seiten 1-10, XP060009093, DOI: 10.1117/12.876981 beschreibt eine gekühlte EUV Kollektoroptik für LPP(Laser produced plasma)- und DPP(discharge produced plasma)-Lichtquellen. Der Fachartikel "Fabrication of EUVL microfield exposure tools with 0.5 NA" von L. Girard et al., OPTOMECHATRONIC MICRO/NANO DEVICES AND COMPONENTS III: 8-10 OCTOBER 2017, LAUSANNE, SWITZERLAND,; [PROCEEDINGS OF SPIE, ISSN 0277-786X], SPIE, BELLINGHAM, WASH, Bd. 9633, 11. Oktober 2015 (2015-10-11), Seiten 96330V-96330V, XP060062765, DOI: 10.1117/12.2203138 ISBN: 978-1-62841-730-2 beschreibt die Herstellung von Werkzeugen zur Beleuchtung von Mikrofeldern mit EUV-Wellenlängen mit einer numerischen Apertur von 0,5.

Die DE 10 2009 044 462 A1 beschreibt ein optisches Element zum Filtern elektromagnetischer Strahlung mit einer Viellagenstruktur, welches in Beleuchtungssystemen und Projektionsbelichtungsanlagen für die EUV-Lithographie zum Einsatz kommen kann.

Die DE 10 2006 022 352 A1 offenbart eine Anordnung zur Projektion eines Musters von einer EUV-Maske auf ein Substrat.

Es ist eine Aufgabe der vorliegenden Erfindung, einen EUV-Kollektor der eingangs genannten Art derart weiterzubilden, dass sich lokale Reflektivitätsunterschiede, insbesondere erzeugt durch Defekte und Verunreinigungen auf dem Kollektor, nicht unerwünscht auf eine Fernfeld-Intensitätsverteilung des EUV-Nutzlichts, welches über den Kollektor geführt ist, auswirken.

Diese Aufgabe ist erfindungsgemäß gelöst durch einen EUV-Kollektor mit den im Anspruch 1 angegebenen Merkmalen und durch einen EUV-Kollektor mit den im Anspruch 6 angegebenen Merkmalen.

Bei dem EUV-Kollektor kann es sich um eine erste, das EUV-Nutzlicht führende Komponente im Strahlengang nach einem Quellbereich einer EUV-Lichtquelle handeln. Die Fernfeld-Intensitätsverteilung liegt in einem Fernfeld des Kollektors vor, in dem eine nachfolgende, das EUV-Nutzlicht führende Komponente der Projektionsbelichtungsanlage anordenbar ist. Bei der Fernfeldebene kann es sich um eine zum Kollektor konjugierte Bildebene handeln. Die Spiegelfläche des EUV-Kollektors dient zur Reflexion des EUV-Nutzlichts. Aufgrund von Streuung an den Oberflächenstrukturen der Spiegelfläche treten Abweichungen von einer idealen Reflexion, insbesondere Abweichungen von einer spekularen Reflexion auf. Bei dem Kollektor kann es sich um mindestens einen Flächenabschnitt eines Ellipsoiden, eines Hyperboloiden, eines Paraboloiden oder einer Sphäre handeln. Auch ein mehrteiliger Kollektor ist möglich.

Der EUV-Kollektor zeichnet sich dadurch aus, dass er Licht mit einer bestimmten Nutzwellenlänge (EUV-Nutzlicht) reflektiert. Der EUV-Kollektor kann das EUV-Nutzlicht auf mindestens einen Zwischenfokus zusammenführen. Ein den Kollektor beinhaltendes Quellmodul kann durch eine nur wenige Millimeter große Öffnung (die sogenannte Zwischenfokusapertur) vom restlichen Optiksystem abgetrennt sein. Für eine punktförmige Lichtquelle kann der Kollektor so ausgelegt werden dass in der Zwischenfokusebene ein punktförmiges Bild entsteht. Durch eine ausgedehnte Lichtquelle kommt es zu einer Verbreiterung der Lichtverteilung in einer gegebenenfalls vorliegenden Zwischenfokusebene. Ein realer Kollektor kann fertigungsbedingt Oberflächenrauigkeiten aufweisen, die zur Streuung des Lichts und damit zu einer weiteren Verbreiterung des Bildes führen. Zu große Streuwinkel haben hierbei zur Folge, dass Licht außerhalb der Zwischenfokusapertur geführt wird und damit nicht mehr als Nutzlicht zur Verfügung steht. Ein hieraus resultierender Transmissionsverlust ist unerwünscht. Eine durch die Ortswellenlängenverteilung bzw. Rauigkeit eingeführte Streuwinkelverteilung führt zu einer lokalen Homogenisierung der Intensitätsverteilung im Fernfeld.

Die Streuwinkelverteilung der Kollektoroberfläche kann so ausgelegt werden, dass die Licht-Verluste an der Zwischenfokusapertur minimiert werden und Licht lediglich innerhalb dieser Apertur umverteilt wird, um den erwünschten Homogenisierungseffekt im Fernfeld zu nutzen.

Der Anteil des in einem bestimmten Winkelbereich gestreuten Lichtes steht in Zusammenhang mit der effektiven Rauheit in einem korrespondierenden Ortswellenlängenbereich der Oberflächenstrukturen auf der Kollektoroberfläche. Die durch die Oberfläche eingeführte Streuwinkelverteilung wird dadurch beeinflusst, dass die Rauheit abhängig von der Ortswellenlänge der Oberflächenstrukturen vorgegeben wird.

Die Rauheit unterhalb einer bestimmten Ortswellenlänge führt zu Verlusten an der Zwischenfokusapertur. Unterhalb dieser unteren Grenz-Ortswellenlänge sollte die effektive Rauheit einer Bedingung genügen, die als Rayleigh smooth-surface Kriterium beschrieben ist in dem Fachbuch "Optical Scattering: Measurement and Analysis" von John C. Stover, SPIE, 2. Auflage 1995 (vgl. dort insbesondere die Formel (3.46)).

Auch unerwünschte Auswirkungen fertigungsbedingter Oberflächenstrukturen, beispielsweise von Kanten eines Gitters zur Unterdrückung unerwünschter Wellenlängen, können durch eine entsprechende Vorgabe der Ortswellenlängenverteilung verringert bzw. vermieden werden. Die Ortswellenlängenverteilung kann an einer Substratoberfläche des EUV-Kollektors vorliegen. Alternativ oder zusätzlich kann die Ortswellenlängenverteilung auch unterhalb einer reflektierenden Oberfläche und insbesondere unterhalb einer reflektierenden Multilagenschicht des EUV-Kollektors vorliegen.

Zwischen der unteren Grenz-Ortswellenlänge und der oberen Grenz-Ortwellenlänge ist die effektive Rauheit gegenüber dem Rayleigh smooth-surface Kriterium um mindestens einen Faktor 1,5, aber um weniger als einen Faktor 6 gezielt erhöht. Durch die Oberflächenstrukturen mit der spezifischen Oberflächenrauhigkeit mit erhöhter effektiver Rauheit oberhalb einer Grenz-Ortswellenlänge wird eine Streuwirkung der Spiegelfläche herbeigeführt, die einerseits so groß ist, dass eine erwünschte Intensitätsverschmierung im Fernfeld des Kollektors stattfindet und andererseits so klein ist, dass keine unerwünschten Nutzlicht-Verluste längst des Nutzlicht-Strahlengangs nach dem EUV-Kollektor resultieren. Erzeugte Streuwinkel können insbesondere so klein sein, dass, soweit der EUV-Kollektor das Nutzlicht in einen Zwischenfokus überführt, eine Zwischenfokusblende auch vom gestreuten Licht ohne unerwünschte Verluste durchtreten wird. Die effektive Rauheit zwischen der unteren und der oberen Grenz-Ortwellenlänge kann im Vergleich zur unterhalb der unteren Grenz-Ortwellenlänge vorliegenden spezifischen Rauheit um mindestens einen Faktor 1,75, um mindestens einen Faktor 2, um mindestens einen Faktor 2,5, um mindestens einen Faktor 3, um mindestens einen Faktor 3,5, um mindestens einen Faktor 4, um mindestens einen Faktor 4,5, um mindestens einen Faktor 5 oder auch um mindestens einen Faktor 5,5 erhöht sein. Alternativ oder zusätzlich kann die effektive Rauheit zwischen der unteren und der oberen Grenz-Ortswellenlänge im Vergleich zur effektiven Rauheit unterhalb der unteren Grenz-Ortwellenlänge um weniger als einen Faktor 5,5, um weniger als einen Faktor 5, um weniger als einen Faktor 4,5, um weniger als einen Faktor 4, um weniger als einen Faktor 3,5, um weniger als einen Faktor 3, um weniger als einen Faktor 2,5 oder auch um weniger als einen Faktor 2 erhöht sein.

Bei der streuenden Spiegelfläche des EUV-Kollektors kann es sich um eine NI-(normal incidence, steiler Einfall)Spiegelfläche mit Einfallswinkeln θ kleiner als 45° oder um eine GI-(grazing incidence, streifender Einfall)Spiegelfläche mit Einfallswinkeln θ größer 45° handeln. Der EUV-Kollektor kann mehrere Spiegelflächen aufweisen, die entsprechende Oberflächenstrukturen zum Streuen der EUV-Nutzwellenlänge aufweisen. Diese Spiegelflächen können alle als NI-Spiegelflächen, alle als GI-Spiegelflächen oder können gemischt aus NI- und GI-Spiegelflächen aufgebaut sein. Ein NI-Einfallswinkel θ kann deutlich kleiner sein als 45°, kann kleiner sein als 35°, kann kleiner sein als 30°, kann kleiner sein als 25°, kann kleiner sein als 20° und kann auch noch kleiner sein. Ein GI-Einfallswinkel θ kann deutlich größer sein als 45°, kann größer sein als 55°, kann größer sein als 60°, kann größer sein als 65°, kann größer sein als 70°, kann größer sein als 75°, kann größer sein als 80°, kann größer sein als 85° und kann auch noch größer sein.

Streuende optische Komponenten in einer Projektionsbelichtungsanlage sind bekannt aus der EP 1 796 147 A1, der DE 10 2012 209 882 A1 und der WO 2013/174644 A1.

Der Kollektor nach Anspruch 1 hat ein Spiegelzentrum, wobei die Ortswellenlängenverteilung derart ist, dass ein Spiegelflächenelement eine zum Spiegelzentrum radiale Streuwinkelverteilung hat, die von einer zum Spiegelzentrum azimutalen Streuwinkelverteilung abweicht. Eine derartige Streuwinkelverteilung kann an Streu-Anforderungen angepasst werden, die sich aufgrund der Auslegung der optischen Komponenten und/oder aufgrund der Strahlführung des EUV-Nutzlichts ergeben. Insbesondere können herstellungspezifische Streufunktionen der optischen Komponenten durch die gezielt herbeigeführte anisotrope Streuwinkelverteilung kompensiert oder korrigiert werden. Auch herstellungsspezifische oder auslegungsbedingte Intensitätsmodulationen, zum Beispiels an Kanten eines aufgebrachten (Über-) Gitters zur Filterung von Wellenlängen, die von der EUV-Nutzwellenlänge abweichen, können durch eine entsprechende anisotrope Streuwinkelverteilung kompensiert oder korrigiert werden.

Eine Grenz-Ortswellenlänge nach Anspruch 2 hat sich in der Praxis bewährt.

Die vorstehend erläuterten Vorteile der Streuwinkelverteilung gelten insbesondere für eine Streuwinkelverteilung nach Anspruch 3. Alternativ ist auch eine Streuwinkelverteilung nach Anspruch 4 möglich.

Eine zusätzliche Gitterstruktur nach Anspruch 5 ermöglicht es, Falschlicht durch Beugung zu unterdrücken.

Bei dem Kollektor nach Anspruch 6 gilt für die untere Grenz-Ortswellenlänge ($P_G$) der Ortswellenlängenverteilung der Oberflächenhöhe die Bedingung, dass $P_G \approx (2L/dIF) \lambda \, 1/\cos\theta$, wobei L einen Abstand zwischen einem die Oberflächenstrukturen aufweisenden, streuenden Spiegelflächenelement und einen Zwischenfokus bezeichnet, in den der EUV-Kollektor einen Quellbereich überführt, und wobei dIF einen zulässigen Durchmesser des Zwischenfokus bezeichnet.

Die Vorteile eines Herstellungsverfahrens nach Anspruch 7 entsprechen denen, die vorstehend unter Bezugnahme auf den erfindungsgemäßen Kollektor bereits beschrieben wurden. Beim Oberflächenbearbeiten kann zwischen der unteren Grenz-Ortswellenlänge und der oberen Grenz-Ortswellenlänge oder alternativ generell oberhalb der unteren Grenz-Ortswellenlänge zusätzlich eine gezielte Erhöhung der effektiven Rauheit herbeigeführt werden, es können im Bereich dieser Ortswellenlängen also gezielt zusätzliche Oberflächenstrukturen eingebracht beziehungsweise zusätzliche Oberflächenrauheit erzeugt werden. Alternativ ist es möglich, keine derartige gezielte Erhöhung der effektiven Rauheit im Vergleich zur ohnehin vorliegenden Ausgangsrauheit zu erzeugen.

Das Oberflächenbearbeiten des Roh-Kollektorsubstrats kann durch Polieren erfolgen. Alternativ oder zusätzlich kann ein Ion-Beam-Figuring (IBF), ein Sandstrahlen, ein Diamantdrehen, ein Fly-Cutting, ein Spin-Coating, eine Beschichtung, ein Ätzen, ein Abformen oder auch ein Aufbringen eines insbesondere glättenden Fluids mit beigemengten Partikeln definierter Größe zur Oberflächenbearbeitung des Roh-Kollektorsubstrats erfolgen. Bei dieser letzten Oberflächenbearbeitungs-Variante durch Fluidaufbringung kann ein Licht-Streuverhalten über eine Größe und/oder über eine Verteilung der Partikel bestimmt werden.

Die beim Herstellungsverfahren bearbeitete Oberfläche des Roh-Kollektorsubstrats ist diejenige Oberfläche, die die Streueigenschaften des Lichts bestimmt. Es kann sich hierbei um eine Multilagen- bzw. Multilayerschicht, beispielsweise um eine MoSi-Multilayerschicht handeln. Alternativ und insbesondere bei Verwendung eines Kollektorspiegels für streifenden Einfall kann es sich bei der zu bearbeitenden Oberfläche des Roh-Kollektorsubstrats um eine Ru-Schicht handeln. Die Rauheit einer derartigen Schicht kann mit einem Bearbeitungsverfahren direkt beeinflusst werden oder aber beeinflusst werden durch ein Bearbeiten einer benachbarten und beispielsweise tieferliegenden Grenzfläche. Oberhalb der reflektierenden Schicht bzw. der reflektierenden Schichten können alternativ oder zusätzlich weitere Schichten aufgebracht werden, die praktisch keine Phasenunterschiede für das Nutzlicht einbringen. Eine Rauheit derartiger weiterer Schichten spielt regelmäßig keine Rolle. Als Bearbeiten einer Oberfläche des Roh-Kollektorsubstrats wird auch verstanden, wenn das Roh-Kollektorsubstrat zunächst mit mindestens einer Schicht beschichtet wird, wobei die mindestens eine aufgebrachte Schicht dann bearbeitet wird.

Die Vorteile eines Beleuchtungssystems nach Anspruch 9 entsprechen denen, die vorstehend unter Bezugnahme auf den EUV-Kollektor beziehungsweise dessen Herstellungsverfahren bereits erläutert wurden.

Bei einer feldnahen Anordnung des EUV-Kollektors nach Anspruch 10 kommen die eingangs erwähnten Vorteile besonders gut zum Tragen. Zur Charakterisierung des Begriffs "feldnah" kann ein Parameter P herangezogen werden, der im Zusammenhang mit der WO 2009/024164 A definiert ist.

Die Vorteile eines Beleuchtungssystems nach Anspruch 11, einer Projektionsbelichtungsanlage nach Anspruch 12, eines Herstellungsverfahrens nach Anspruch 13 entsprechen denen, die vorstehend unter Bezugnahme auf den EUV-Kollektor, dessen Herstellungsverfahren und das Beleuchtungssystem bereits erläutert wurden.

Hergestellt werden kann mit der Projektionsbelichtungsanlage insbesondere ein Halbleiter-Bauteil, beispielsweise ein Speicherchip.

Ausführungsbeispiele der Erfindung werden nachfolgend anhand der Zeichnung näher erläutert. In dieser zeigen:

Fig. 1    schematisch eine Projektionsbelichtungsanlage für die EUV-Mikrolithographie;

Fig. 2    in einem Meridionalschnitt einen Lichtweg hin zu und von einem Plasma-Quellbereich einer EUV-Lichtquelle der Projektionsbelichtungsanlage nach Fig. 1, wobei insbesondere eine beugende, falschlichtunterdrückende Wirkung eines EUV-Kollektorspiegels dargestellt ist, der eine erste, EUV-Nutzlicht führende Komponente nach dem EUV-Quellbereich darstellt;

Fig. 3    im Vergleich zur Fig. 2 stärker schematisch den EUV-Kollektor, wobei eine für das EUV-Nutzlicht streuende Wirkung eines Spiegelflächenelements des EUV-Kollektors mit übertrieben großem Streuwinkel bis zu einem Zwischenfokus des Strahlengangs des EUV-Nutzlichts dargestellt ist;

Fig. 4    stark schematisch eine Oberflächenstruktur einer Spiegelfläche des EUV-Kollektors zur Verdeutlichung einer Ortswellenlänge und eines Gradientenwinkels;

Fig. 5    schematisch den Kollektor aus Blickrichtung V in Fig. 2, wobei eine 2D-Streuwinkelverteilung für ein Spiegelflächenelement dargestellt ist, die in radialer Richtung genauso groß ist wie in azimutaler Richtung;

Fig. 6    in einem Diagramm die Abhängigkeit einer Streuintensität von einem Streuwinkel bei der Streuwinkelverteilung nach Fig. 5;

Fig. 7    in einer zu Fig. 5 ähnlichen Darstellung eine weitere Ausführung einer 2D-Streuwinkelverteilung eines Spiegelflächenelements, wobei eine radiale Streuwinkelverteilung von einer azimutalen Streuwinkelverteilung abweicht;

Fig. 8    in einem zu Fig. 6 ähnlichen Diagramm die Abhängigkeit der Intensität vom Streuwinkel bei der Streuwinkelverteilung nach Fig. 7;

Fig. 9    die Abhängigkeit einer spektralen Leistungsdichte von einer Ortswellenlänge im Zuge eines Herstellungsverfahrens für einen EUV-Kollektor; und

Fig. 10 und 11　weitere Ausführungen einer Abhängigkeit der spektralen Leistungsdichte von einer Ortswellenlänge für weitere Varianten eines Herstellungsverfahrens für einen EUV-Kollektor.

Eine Projektionsbelichtungsanlage 1 für die Mikrolithographie hat eine Lichtquelle 2 für Beleuchtungslicht bzw. Abbildungslicht 3, die nachfolgend noch weiter erläutert wird. Bei der Lichtquelle 2 handelt es sich um eine EUV-Lichtquelle, die Licht in einem Wellenlängenbereich beispielsweise zwischen 5 nm und 30 nm, insbesondere zwischen 5 nm und 15 nm, erzeugt. Das Beleuchtungs- bzw. Abbildungslicht 3 wird nachfolgend auch als EUV-Nutzlicht bezeichnet.

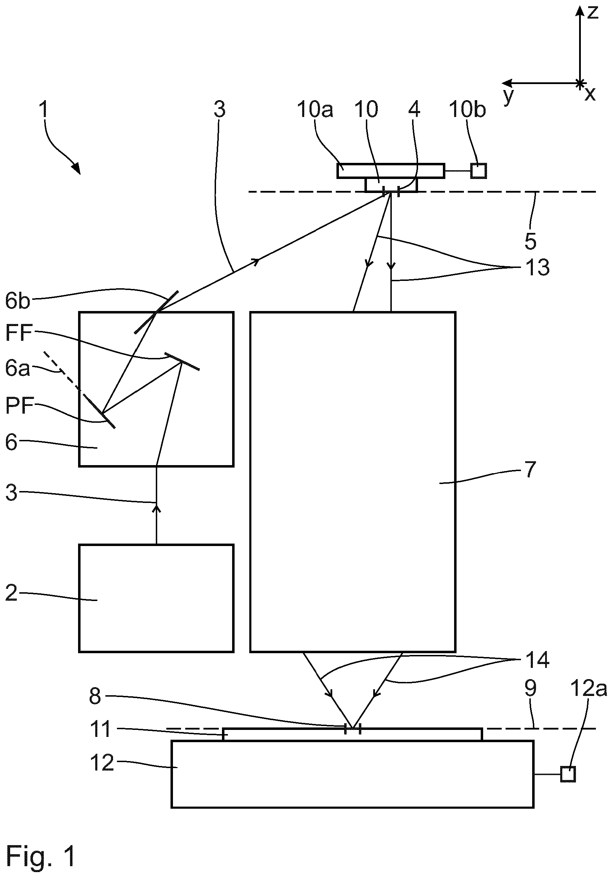

Bei der Lichtquelle 2 kann es sich insbesondere um eine Lichtquelle mit einer EUV-Nutzwellenlänge von 13,5 nm oder um eine Lichtquelle mit einer EUV-Nutzwellenlänge von 6,9 nm oder 7 nm handeln. Auch andere EUV-Nutzwellenlängen sind möglich. Ein Strahlengang des Beleuchtungslichts 3 ist in der Fig. 1 äußerst schematisch dargestellt.

Zur Führung des Beleuchtungslichts 3 von der Lichtquelle 2 hin zu einem Objektfeld 4 in einer Objektebene 5 dient eine Beleuchtungsoptik 6. Letztere umfasst einen in der Fig. 1 stark schematisch dargestellten Feldfacettenspiegel FF und einen im Strahlengang des Beleuchtungslichts 3 nachfolgenden, ebenfalls stark schematische dargestellten Pupillenfacettenspiegel PF. Zwischen dem Pupillenfacettenspiegel PF, der in einer Pupillenebene 6a der Beleuchtungsoptik angeordnet ist, und dem Objektfeld 4 ist ein feldformender Spiegel 6b für streifenden Einfall (GI-Spiegel, grazing incidence Spiegel) im Strahlengang des Beleuchtungslichts 3 angeordnet. Ein derartiger GI-Spiegel 6b ist nicht zwingend.

Nicht näher dargestellte Pupillenfacetten des Pupillenfacettenspiegels PF sind Teil einer Übertragungsoptik, die ebenfalls nicht dargestellte Feldfacetten des Feldfacettenspiegels FF einander überlagernd in das Objektfeld 4 überführen und insbesondere abbilden. Für den Feldfacettenspiegel FF einerseits und den Pupillenfacettenspiegel PF andererseits kann eine Ausführung genutzt werden, die aus dem Stand der Technik bekannt ist. Eine derartige Beleuchtungsoptik ist beispielsweise bekannt aus der DE 10 2009 045 096 A1.

Mit einer Projektionsoptik bzw. abbildenden Optik 7 wird das Objektfeld 4 in ein Bildfeld 8 in einer Bildebene 9 mit einem vorgegebenen Verkleinerungsmaßstab abgebildet. Hierfür einsetzbare Projektionsoptiken sind beispielsweise bekannt aus der DE 10 2012 202 675 A1.

Zur Erleichterung der Beschreibung der Projektionsbelichtungsanlage 1 sowie der verschiedenen Ausführungen der Projektionsoptik 7 ist in der Zeichnung ein kartesisches xyz-Koordinatensystem angegeben, aus dem sich die jeweilige Lagebeziehung der in den Figuren dargestellten Komponenten ergibt. In der Fig. 1 verläuft die x-Richtung senkrecht zur Zeichenebene in diese hinein. Die y-Richtung verläuft in der Fig. 1 nach links und die z-Richtung in der Fig. 1 nach oben. Die Objektebene 5 verläuft parallel zur xy-Ebene.

Das Objektfeld 4 und das Bildfeld 8 sind rechteckförmig. Alternativ ist es auch möglich, das Objektfeld 4 und Bildfeld 8 gebogen bzw. gekrümmt, also insbesondere teilringförmig auszuführen. Das Objektfeld 4 und das Bildfeld 8 haben ein xy-Aspektverhältnis größer als 1. Das Objektfeld 4 hat also eine längere Objektfelddimension in der x-Richtung und eine kürzere Objektfelddimension in der y-Richtung. Diese Objektfelddimensionen verlaufen längs der Feldkoordinaten x und y.

Für die Projektionsoptik 7 kann eines der aus dem Stand der Technik bekannten Ausführungsbeispiele eingesetzt werden. Abgebildet wird hierbei als Objekt mit dem Objektfeld 4 zusammenfallender Ausschnitt einer Reflexionsmaske 10, die auch als Retikel bezeichnet wird. Das Retikel 10 wird von einem Retikelhalter 10a getragen. Der Retikelhalter 10a wird von einem Retikelverlagerungsantrieb 10b verlagert.

Die Abbildung durch die Projektionsoptik 7 erfolgt auf die Oberfläche eines Substrats 11 in Form eines Wafers, der von einem Substrathalter 12 getragen wird. Der Substrathalter 12 wird von einem Wafer- bzw. Substratverlagerungsantrieb 12a verlagert.

In der Fig. 1 ist schematisch zwischen dem Retikel 10 und der Projektionsoptik 7 ein in diese einlaufendes Strahlenbündel 13 des Beleuchtungslichts 3 und zwischen der Projektionsoptik 7 und dem Substrat 11 ein aus der Projektionsoptik 7 auslaufendes Strahlenbündel 14 des Beleuchtungslichts 3 dargestellt. Eine bildfeldseitige numerische Apertur (NA) der Projektionsoptik 7 ist in der Fig. 1 nicht maßstäblich wiedergegeben.

Die Projektionsbelichtungsanlage 1 ist vom Scannertyp. Sowohl das Retikel 10 als auch das Substrat 11 werden beim Betrieb der Projektionsbelichtungsanlage 1 in der y-Richtung gescannt. Auch ein Steppertyp der Projektionsbelichtungsanlage 1, bei dem zwischen einzelnen Belichtungen des Substrats 11 eine schrittweise Verlagerung des Retikels 10 und des Substrats 11 in der y-Richtung erfolgt, ist möglich. Diese Verlagerungen erfolgen synchronisiert zueinander durch entsprechende Ansteuerung der Verlagerungsantriebe 10b und 12a.

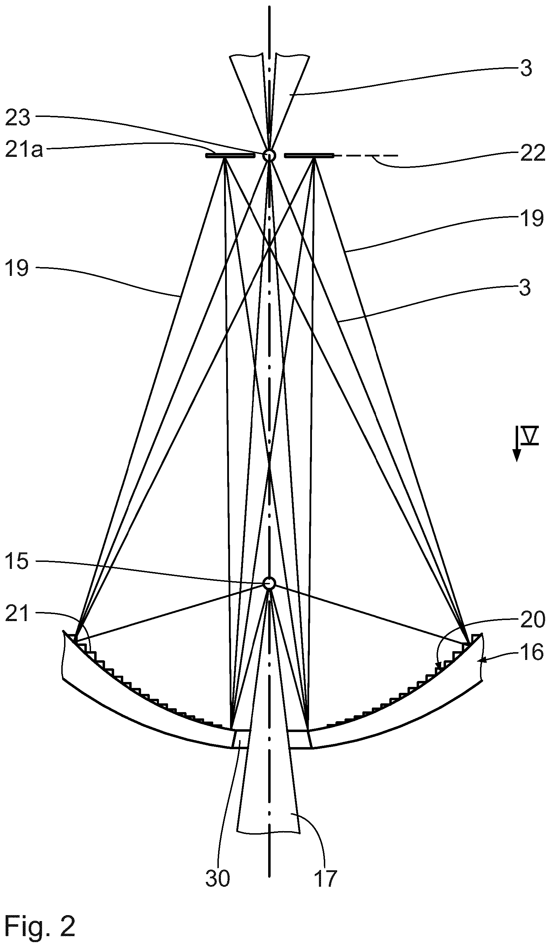

Fig. 2 zeigt einen Strahlengang hin zu und von einem Quellbereich 15 der EUV-Lichtquelle 2 und zeigt insbesondere eine falschlichtunterdrückende Wirkung eines EUV-Kollektors 16.

Pumplicht 17, zum Beispiel die Emission eines $CO_2$-Lasers, wird in den Quellbereich 15 fokussiert und interagiert mit einem nicht näher dargestellten Targetmedium, welches einerseits EUV-Nutzlicht 3 mit einer EUV-Nutzwellenlänge, zum Beispiels von 6,9 nm oder von 13 nm, und Falschlicht 19 mit einer von der EUV-Nutzwellenlänge abweichenden Wellenlänge abstrahlt.

Sowohl das EUV-Nutzlicht 3 als auch das Falschlicht 19 werden von einer Spiegelfläche 20 des EUV-Kollektors 16 reflektiert.

Die Spiegelfläche 20 weist eine Gitterstruktur 21 auf, die in der Fig. 2 nicht maßstabsgetreu dargestellt ist. Die Gitterstruktur 21 dient zur beugenden Ablenkung des Falschlichts 19, sodass ausschließlich das EUV-Nutzlicht 3 eine Zwischenfokusblende 21a passiert, die in einer Zwischenfokusebene 22 angeordnet ist. Die Zwischenfokusebene 22 stellt eine Bildebene des Quellbereichs 15 dar. Entsprechend ist die Spiegelfläche 20 des EUV-Kollektors 16 mit der Grundform einer Kegelschnitt-Fläche ausgeführt. Bei der in der Fig. 2 dargestellten Ausführung ist die Spiegelfläche 20 mit der Grundform einer Ellipsoid-Fläche ausgeführt, in deren einem Brennpunkt der Quellbereich 15 angeordnet ist und in deren anderem Brennpunkt ein Zwischenfokus 23 in der Zwischenfokusebene 22 liegt.

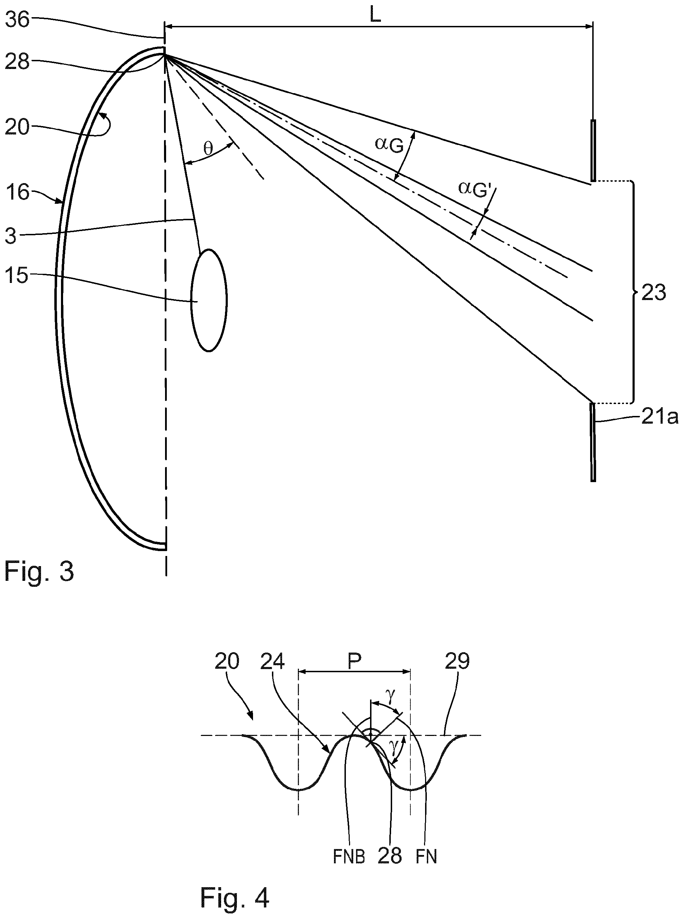

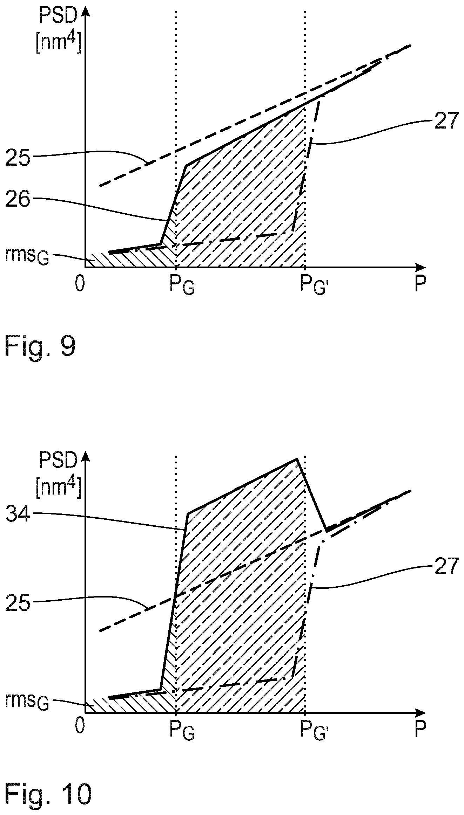

Zusätzlich zur Gitterstruktur 21 hat die Spiegelfläche 20 Oberflächenstrukturen 24, die in der Fig. 4 stark schematisch dargestellt sind. Die Oberflächenstrukturen können als Variation einer Oberflächenhöhe bzw. Oberflächenrauheit der Spiegelfläche 20 beschrieben werden. Die Oberflächenstrukturen 24 dienen zum Streuen der EUV-Nutzwellenlänge des Nutzlichts 3. Aufgrund der Oberflächenstrukturen 24 hat die Spiegelfläche 20 eine Oberflächenrauhigkeit. Diese Oberflächenrauhigkeit ergibt eine Oberflächenstrukturverteilung abhängig von Ortswellenlängen P (vgl. z. B. Fig. 4) oberhalb einer Grenz-Ortswellenlänge $P_G$ (vgl. z. B. Fig. 9). Oberflächenstrukturen mit Ortswellenlängen unterhalb der Grenz-Ortswellenlänge $P_G$ sind durch eine entsprechende Oberflächenbearbeitung, insbesondere eine Glättung oder eine Politur, stark reduziert, sodass für eine effektive Rauheit $rms_G$ für Ortswellenlängen P unterhalb der Grenz-Ortswellenlänge $P_G$ gilt:

$$(4 \pi \, rms_G \, \cos(\theta)/\lambda)^2 < 0,1$$

$\lambda$ ist dabei die EUV-Nutzwellenlänge. $\theta$ ist dabei der Einfallswinkel des EUV-Nutzlichts 3 auf der Spiegelfläche 20.

Die Relation für die effektive Rauheit $rms_G$ hängt abgesehen vom Einfallswinkel $\theta$ nur von der Nutzlicht-Wellenlänge $\lambda$ ab. Für $\lambda$ = 13,5 nm und $\theta$ = 0 gilt: $rms_G \leq 0,35$ nm.

Die effektive Rauheit rms ergibt sich als Integral eines Bereichs zwischen zwei verschiedenen Grenz-Ortswellenlängen. Eine effektive Rauheit $rms_{GG'}$ der Spiegelfläche 20 ist oberhalb der unteren Grenz-Ortswellenlänge $P_G$ und unterhalb der oberen Grenz-Ortswellenlänge $P_{G'}$, also zwischen der unteren und der oberen Grenz-Ortswellenlänge, mindestens anderthalbmal so groß, aber nicht größer als sechsmal so groß wie unterhalb der unteren Grenz-Ortswellenlänge $P_G$.

Im Bereich der unteren Grenz-Ortswellenlänge $P_G$ kann eine effektive Rauheit $rms_{GG'}$ vorliegen, die im Bereich von 0,53 nm liegt, wobei 0,53 nm eine Untergrenze für diese effektive Rauheit darstellt. Im Bereich der oberen Grenz-Ortswellenlänge $P_{G'}$ kann eine effektive Rauheit $rms_{GG'}$ vorliegen, die im Bereich von 2,1 nm liegt, wobei 2,1 nm die Obergrenze dieser effektiven Rauheit darstellt.

Die Politur der Spiegelfläche 20 bei Ortswellenlängen unterhalb der Grenz-Ortwellenlänge $P_G$ kann so sein, dass diese Ortswellenlängen zu einer spektralen Leistungsdichte (power spectral density, PSD) praktisch nicht beitragen.

Die spektrale Leistungsdichte PSD ist in der Fig. 9 in der Einheit [$nm^4$] angegeben. Details zur Definition der spektralen Leistungsdichte finden sich in dem Fachbuch "Optical Scattering: Measurement and Analysis" von John C. Stover, SPIE, 2. Auflage 1995 und 3. Auflage 2012, und im Artikel "Power Spectral Density (PSD)" auf den Internetseiten www.nanophys.kth.se.

Eine Messmethode einerseits für die spektrale Leistungsdichte PSD und andererseits für die effektive Rauheit rms kann dem Fachartikel "Surface characterization techniques for determening the root-mean-square roughness and power spectral densities of optical components" von Duparre et al., Applied Optics, Vol. 41, Nr. 1, 01.01.2002, entnommen werden. Im Abschnitt "3. Instruments" werden verschiedene Messgeräte in diesem Fachartikel diskutiert. Im Abschnitt "4. Calculation of the Power Spectal Density Function and the rms roughness" ist in diesem Fachartikel angegeben, wie aus den gewonnenen Messdaten einerseits die spektrale Leistungsdichte PSD und andererseits die effektive Rauheit rms, dort bezeichnet als $\sigma_{rms}$, berechnet werden.

Sowohl hinsichtlich der PSD als auch hinsichtlich der Ortswellenlänge liegt eine logarithmische Skalierung bei der Fig. 9 vor. Die jeweiligen rms-Werte für die effektive Rauheit ergeben sich aus der PSD-Darstellung nach Fig. 9 anhand folgender Beziehung:

$$rms^2 = 2 \cdot \int_{f1}^{f2} 2\pi f \cdot PSD(f) \cdot df$$

Die effektive Rauheit $rms_G$ unterhalb der unteren Grenz-Ortswellenlänge $P_G$ ergibt sich aus dieser Beziehung durch Wahl der Integrationsgrenzen f1 = $1/P_G$ und f2 = $1/\lambda_{EUV}$. $\lambda_{EUV}$ ist hierbei die EUV-Nutzwellenlänge. $rms_G$ ist in der Fig. 9 wiedergegeben durch eine mit durchgezogenen Linien schraffierte Fläche. Die effektive Rauheit $rms_{GG'}$ zwischen der unteren Grenz-Ortswellenlänge $P_G$ und der oberen Grenz-Ortswellenlänge $P_{G'}$ ergibt sich aus der obigen Beziehung durch Einsetzen der Grenzen f1 = $1/P_{G'}$ und f2 = $1/P_G$. $rms_{GG'}$ ist in der Fig. 9 wiedergegeben durch eine abwechselnd durchgezogen und gestrichelt schraffierte Fläche.

Fig. 9 zeigt, wie eine solche Ortswellenlängenverteilung auf der Spiegelfläche 20 des EUV-Kollektors 16 hergestellt wird. Zunächst wird ein Roh-Kollektorsubstrat bereitgestellt, welches über alle Ortswellenlängen eine Ausgangsrauheit 25 aufweist, die in der Fig. 9 gestrichelt dargestellt ist. Anschließend wird eine Oberfläche des Roh-Kollektorsubstrats bearbeitet, dieses also beispielsweise poliert, sodass die effektive Rauheit rms nur unterhalb der Grenz-Ortswellenlänge P$_G$ im Vergleich zur Ausgangsrauheit 25 um mehr als einen Faktor 2 reduziert wird. Ergebnis ist eine Ziel-Rauheit 26, die in der Fig. 9 als durchgezogene Linie dargestellt ist. Oberhalb der Grenz-Ortswellenlänge P$_G$ erfolgt kein oder allenfalls ein geringes Auspolieren von Oberflächenstrukturen der Ausgangsrauheit 25, sodass diese Oberflächenstrukturen zumindest zum Großteil erhalten bleiben.

Dieses Herstellungsverfahren unterscheidet sich von einer typischen Spiegelpolitur, bei der die Ausgangsrauheit 25 bis zu einer Grenz-Ortswellenlänge P$_{G'}$ auspoliert wird. Das Ergebnis dieser typischen Spiegelpolitur ist in der Fig. 9 durch eine strichpunktierte Kurve 27 (typische Rauheit) dargestellt. Die Grenz-Ortswellenlänge P$_{G'}$ der typischen Rauheit 27 kann größer sein als 10 μm und kann insbesondere größer sein als 50 μm. Die obere Grenz-Ortswellenlänge P$_{G'}$ kann beispielsweise im Bereich von 100 μm liegen.

Die Grenz-Ortswellenlänge P$_G$ bei der Zielrauheit 26 liegt im Bereich zwischen 1 μm und 100 μm. Diese Grenz-Ortswellenlänge P$_G$ kann größer sein als 2 μm, kann größer sein als 5 μm, kann im Bereich von 6 μm liegen, kann größer sein als 8 μm, kann größer sein als 10 μm, kann größer sein als 15 μm, kann größer sein als 20 μm, kann größer sein als 50 μm. Die Grenz-Ortswellenlänge P$_G$ kann kleiner sein als 90 μm, kann kleiner sein als 80 μm, kann kleiner sein als 70 μm, kann kleiner sein als 50 μm, kann kleiner sein als 20 μm und kann kleiner sein als 10 μm.

Fig. 3 und 4 zeigen typische Größen, mit deren Hilfe die Ortswellenlänge P abgeschätzt werden kann. Mit L ist in der Fig. 3 ein Abstand zwischen einem jeweils streuenden Spiegelflächenelement 28 und dem Zwischenfokus 23 bezeichnet. Mit dIF ist ein maximal zulässiger Durchmesser des Zwischenfokus 23 bezeichnet, der mit einer Öffnung der Zwischenfokusblende 21a übereinstimmt. Mit α ist in der Fig. 3 ein typischer Streuwinkel des Spiegelflächenelements 28 bezeichnet. Dieser Streuwinkel α ist der Fig. 3 übertrieben groß dargestellt. Mit 29 ist in der Fig. 4 eine Kegelschnitt-Fläche bezeichnet, an die die Spiegelfläche 20 mit dem Spiegelflächenelement 28 bestangepasst ist. Die Kegelschnitt-Fläche 29 ist durch eine rotationssymmetrische Funktion beschreibbar. Mit FN ist eine Normale auf das Spiegelflächenelement 28 bezeichnet. Mit FNB ist eine Normale auf die Kegelschnitt-Fläche 29 bezeichnet. Zwischen diesen beiden Normalen FN und FNB liegt ein Gradientenwinkel γ vor.

Es gelten folgende Beziehungen:

$$\sin(\alpha) = \lambda/(P\cos\theta)$$

Hierbei ist α der Streuwinkel, λ die EUV-Nutzwellenlänge und P die Ortswellenlänge der Oberflächenstruktur. θ ist der Einfallswinkel des Beleuchtungslichts 3 auf dem Spiegelflächenelement 28.

Weiterhin gilt:

$$\sin(\alpha_G) \approx dIF/2L$$

Hierbei ist α$_G$ beziehungsweise α$_{max}$ der maximal zulässige Streuwinkel, dIF der zulässige Durchmesser des Zwischenfokus 23 (= Öffnungsweite der Zwischenfokusblende 21a) und L der Abstand zwischen dem Spiegelflächenelement 28 und dem Zwischenfokus 23. Die obige Beziehung für α$_G$ gilt näherungsweise für dIF/L < 1.

Diese Formeln sind beispielhaft für eine Streurichtung in einer Ebene, die durch eine Richtung eines einfallenden Strahls und eine Normale auf der Oberfläche des Kollektors, also insbesondere des Spiegelflächenelements 28, definiert ist. Für die Streuung aus dieser Ebene gelten angepasste Formeln und diesbezüglich wird verwiesen auf das Fachbuch "Optical Scattering: Measurement and Analysis" von John C. Stover, SPIE, 2. Auflage 1995 und 3. Auflage 2012.

Durch Elimination des Streuwinkels α ergibt sich aus den beiden vorstehenden Formeln:

$$P_G \approx (2L/dIF)\,\lambda\,1/\cos\theta$$

für die untere Grenz-Ortswellenlänge P$_G$. Die obere Grenz-Ortwellenlänge P$_{G'}$ ist mindestens zehnmal so groß wie die untere Grenz-Ortwellenlänge P$_G$ und kann beispielsweise fünfzehnmal so groß sein. Entsprechend ist der Streuwinkel α$_G$ bei der unteren Grenz-Ortswellenlänge P$_G$ etwa fünfzehnmal so groß wie der Streuwinkel α$_{G'}$ bei der oberen Grenz-Ortswellenlänge P$_{G'}$. Die vorstehende Formel gilt näherungsweise für kleine Streuwinkel α.

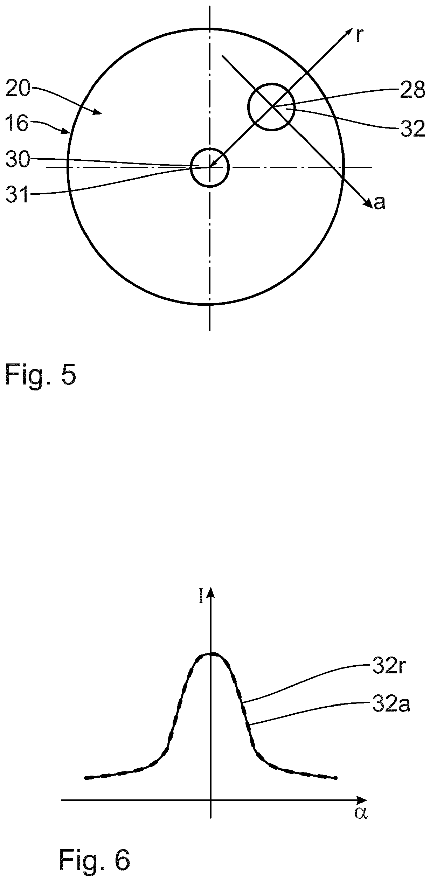

Wie in der Fig. 2 dargestellt, durchtritt das Pumplicht 17 eine Durchtrittsöffnung 30 im Bereich eines Spiegelzentrums 31 der Spiegelfläche 20 des EUV-Kollektors 16 (vgl. auch die Fig. 5 und 6). Das Pumplicht kann auch in anderer Weise eingestrahlt werden, beispielsweise über einen weiteren Umlenkspiegel aus einer Richtung senkrecht zur Zeichenebene der Fig. 2.

Fig. 5 verdeutlicht eine 2D-Streuwinkelverteilung 32 eines Spiegelflächenelementes 28. Diese Streuwinkelverteilung ist derart, dass sie in radialer Richtung r genauso groß ist wie in azimutaler Richtung a. Die Streuwinkelverteilung 32 nach Fig. 5 ist insbesondere isotrop.

Diese Isotropie der 2D-Streuwinkelverteilung 32 ist in der Fig. 6 ebenfalls dargestellt, die die Abhängigkeit einer Streuintensität I vom Streuwinkel α darstellt. Diese Abhängigkeit ist für die radiale Richtung r (durchgezogene Linie in der Fig. 6, Streuwinkelverteilung 32r) genauso groß wie für die azimutale Richtung a (gestrichelte Linie in der Fig. 6, Streuwinkelverteilung 32a).

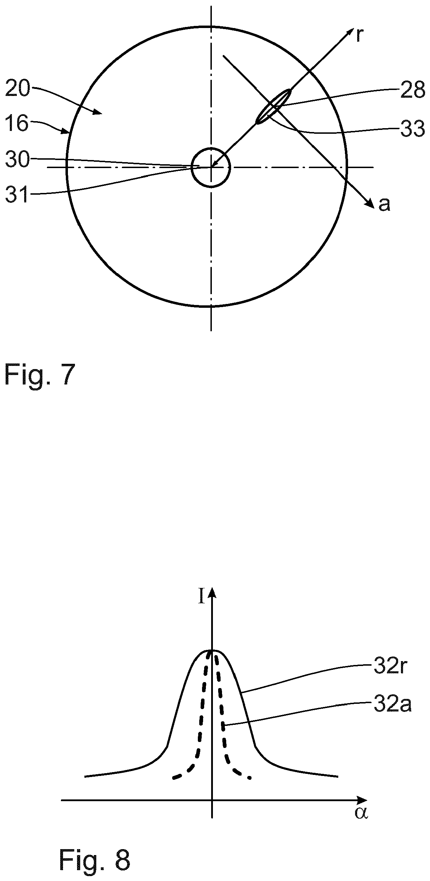

Anhand der Fig. 7 und 8 wird eine alternative 2D-Streuwinkelverteilung 33 des Spiegelflächenelements 28 erläutert. Diese Streuwinkelverteilung 33 ist anisotrop und in der radialen Richtung r um ein Mehrfaches größer als in der azimutalen Richtung a. Entsprechend ist eine Breite einer Verteilung der Streuintensität I über den Streuwinkel $\alpha$ bei der Streuwinkelverteilung 33 in radialer Richtung r (durchgezogene Linie in der Fig. 8, Streuwinkelverteilung 32r) um ein Mehrfaches größer als in azimutaler Richtung a (gestrichelte Linie in der Fig. 8, Streuwinkelverteilung 32a). Für ein Verhältnis der Breiten FWHM (volle Halbwertsbreite, full width half max) der I($\alpha$)-Kurven 32r und 32a kann gelten: FWHM (Ir($\alpha$))/FWHM (Ia($\alpha$)) $\geq$ 2. Dieses Verhältnis kann auch größer sein als 3, kann größer sein als 4 und kann auch noch größer sein.

Mit Hilfe der anisotropen 2D-Streuwinkelverteilung 33 können beispielsweise rotationssymmetrische Defekte geglättet werden, die durch das Herstellungsverfahren der Spiegelfläche 20 entstehen können.

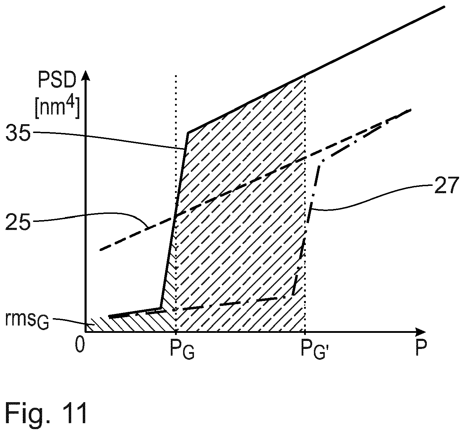

Anhand der Fig. 10 und 11 werden zwei weitere Ausführungen eines Verfahrens zur Herstellung der Spiegelfläche 20 des EUV-Kollektors 16 dargestellt. Komponenten, Funktionen und Größen, die denjenigen entsprechen, die vorstehend unter Bezugnahme auf das Herstellungsverfahren nach Fig. 9 bereits erläutert wurden, tragen die gleichen Bezugsziffern und werden nicht nochmals im Einzelnen diskutiert.

Beim Herstellungsverfahren nach Fig. 10 wird zwischen den Grenz-Ortswellenlängen $P_G$ und $P_{G'}$ im Vergleich zur Ausgangsrauheit 25 zusätzliche Oberflächenrauheit gezielt erzeugt, sodass eine Ziel-Rauheit 34 im Bereich zwischen den Grenz-Ortswellenlängen $P_G$ und $P_{G'}$ deutlich größer ist als die Ausgangsrauheit 25. Für die effektive Rauheit rms kann gelten, dass diese im Bereich zwischen den Grenz-Ortswellenlängen $P_G$ und $P_{G'}$ im Vergleich zur Ausgangsrauheit 25 um mehr als 10%, mehr als 20%, mehr als 30% oder auch um mehr als 50% größer ist.

Oberhalb der Grenz-Ortswellenlänge $P_{G'}$ des typischen Spiegelherstellungsverfahrens geht die Ziel-Rauheit 34 wieder in die Ausgangsrauheit 25 über.

Beim Herstellungsverfahren nach Fig. 11 wird eine Ziel-Rauheit 35 erzeugt, die oberhalb der Grenz-Ortswellenlänge $P_G$ insgesamt größer ist als die Ausgangsrauheit 25, also auch oberhalb der Grenz-Ortswellenlänge $P_{G'}$ des typischen Spiegel-Herstellungsverfahrens.

Der EUV-Kollektor 16 ist in Bezug auf eine zur Objektebene 5 konjugierte Feldebene, die beispielsweise am Ort der Ebene 36 in der Fig. 3 liegen kann, feldnah angeordnet.

Zur Charakterisierung der Positionierung "feldnah" des Kollektors 16 zur Feldebene 36 wird ein Parameter P herangezogen, für den gilt:

$$P(M) = D(SA)/(D(SA)+D(CR))$$

Hierbei gilt:

D(SA) ist der Durchmesser einer Subapertur, also der zu genau einem Feldpunkt gehörenden Beleuchtungslichtstrahlen, auf der Spiegelfläche des Kollektors 16;

D(CR) ist ein maximaler Abstand von Hauptstrahlen, die von der Feldebene ausgehen, auf der Spiegelfläche des Kollektors 16.

Diese Definition des Parameters P findet sich beispielsweise in der WO 2009/024164 A.

Soweit der Kollektor 16 exakt in der Feldebene 36 angeordnet ist, gilt P = 0, da dann D(CR) ungleich Null ist und D(SA) gleich Null ist. Soweit der Kollektor 16 in einer Pupillenebene angeordnet wäre, würde gelten P = 1, da D(CR) dann gleich Null ist und D(SA) ungleich Null ist.

Zur Herstellung eines mikro- oder nanostrukturierten Bauteils wird die Projektionsbelichtungsanlage 1 folgendermaßen eingesetzt: Zunächst werden die Reflexionsmaske 10 bzw. das Retikel und das Substrat bzw. der Wafer 11 bereitgestellt. Anschließend wird eine Struktur auf dem Retikel 10 auf eine lichtempfindliche Schicht des Wafers 11 mithilfe der Projektionsbelichtungsanlage 1 projiziert. Durch Entwicklung der lichtempfindlichen Schicht wird dann eine Mikro- oder Nanostruktur auf dem Wafer 11 und somit das mikrostrukturierte Bauteil erzeugt.

**Patentansprüche**

1. EUV-Kollektor (16) zum Einsatz in einer EUV-Projektionsbelichtungsanlage (1),

   - mit mindestens einer Spiegelfläche (20), die Oberflächenstrukturen (24) zum Streuen einer EUV-Nutzwellenlänge ($\lambda$) von EUV-Nutzlicht (3) aufweist,
   - wobei die Spiegelfläche (20) eine Oberflächenhöhe mit einer Ortswellenlängenverteilung (26; 34; 35) zwischen einer unteren Grenz-Ortswellenlänge ($P_G$) und einer oberen Grenz-Ortswellenlänge ($P_{G'}$) aufweist,
   - wobei die untere Grenz-Ortswellenlänge ($P_G$) im Bereich zwischen 1 $\mu$m und 100 $\mu$m liegt,
   - wobei die obere Grenz-Ortswellenlänge ($P_{G'}$) mindestens zehnmal so groß ist wie die untere Grenz-Ortswellenlänge ($P_G$),
   - wobei eine effektive Rauheit ($rms_G$) unterhalb der unteren Grenz-Ortswellenlänge ($P_G$) folgender Relation genügt:

$$(4\,\pi\,rms_G\cos(\theta)/\lambda)^2 < 0,1$$

   - wobei $\theta$ einen Einfallswinkel des EUV-Nutzlichts (3) auf der Spiegelfläche (20) bezeichnet,
   - wobei für eine effektive Rauheit ($rms_{GG'}$) zwischen der unteren Grenz-Ortswellenlänge ($P_G$) und der oberen Grenz-Ortswellenlänge ($P_{G'}$) gilt:

$$1{,}5\,\mathrm{rms_G} < \mathrm{rms_{GG'}} < 6\,\mathrm{rms_G},$$

**dadurch gekennzeichnet, dass** der Kollektor (16) ein Spiegelzentrum (31) hat, wobei die Ortswellenlängenverteilung (26; 34; 35) derart ist, dass ein Spiegelflächenelement (28) eine zum Spiegelzentrum (31) radiale Streuwinkelverteilung (33r) hat, die von einer zum Spiegelzentrum (31) azimutalen Streuwinkelverteilung (33a) abweicht.

2. EUV-Kollektor nach Anspruch 1, **dadurch gekennzeichnet, dass** die Grenz-Ortswellenlänge ($P_G$) größer ist als 5 $\mu$m.

3. EUV-Kollektor nach Anspruch 1 oder 2, **dadurch gekennzeichnet, dass** die radiale Streuwinkelverteilung (33r) einen größeren Streuwinkelbereich abdeckt als die azimutale Streuwinkelverteilung (33a).

4. EUV-Kollektor nach Anspruch 1 oder 2, **dadurch gekennzeichnet, dass** die azimutale Streuwinkelverteilung einen größeren Streuwinkelbereich abdeckt als die radiale Streuwinkelverteilung.

5. EUV-Kollektor nach einem der Ansprüche 1 bis 4, **dadurch gekennzeichnet, dass** mindestens ein Abschnitt der Spiegelfläche (20) eine Gitterstruktur (21) zur Beugung von Falschlicht (19) aufweist, dessen Wellenlänge von der EUV-Nutzwellenlänge abweicht.

6. EUV-Kollektor (16) zum Einsatz in einer EUV-Projektionsbelichtungsanlage (1),

   - mit mindestens einer Spiegelfläche (20), die Oberflächenstrukturen (24) zum Streuen einer EUV-Nutzwellenlänge ($\lambda$) von EUV-Nutzlicht (3) aufweist,
   - wobei die Spiegelfläche (20) eine Oberflächenhöhe mit einer Ortswellenlängenverteilung (26; 34; 35) zwischen einer unteren Grenz-Ortswellenlänge ($P_G$) und einer oberen Grenz-Ortswellenlänge ($P_{G'}$) aufweist,
   - wobei die untere Grenz-Ortswellenlänge ($P_G$) im Bereich zwischen 1 $\mu$m und 100 $\mu$m liegt,
   - wobei die obere Grenz-Ortswellenlänge ($P_{G'}$) mindestens zehnmal so groß ist wie die untere Grenz-Ortswellenlänge ($P_G$),
   - wobei eine effektive Rauheit ($\mathrm{rms_G}$) unterhalb der unteren Grenz-Ortswellenlänge ($P_G$) folgender Relation genügt:

$$(4\,\pi\,\mathrm{rms_G}\cos(\theta)/\lambda)^2 < 0{,}1$$

   - wobei $\theta$ einen Einfallswinkel des EUV-Nutzlichts (3) auf der Spiegelfläche (20) bezeichnet,
   - wobei für eine effektive Rauheit ($\mathrm{rms_{GG'}}$) zwischen der unteren Grenz-Ortswellenlänge ($P_G$) und der oberen Grenz-Ortswellenlänge ($P_{G'}$) gilt:

$$1{,}5\,\mathrm{rms_G} < \mathrm{rms_{GG'}} < 6\,\mathrm{rms_G},$$

   **dadurch gekennzeichnet, dass** für die untere Grenz-Ortswellenlänge ($P_G$) der Ortswellenlängenverteilung der Oberflächenhöhe folgende Bedingung gilt:

$$P_G \approx (2L/dIF)\,\lambda\,1/\cos\theta,$$

   - wobei L einen Abstand zwischen einem die Oberflächenstrukturen aufweisenden, streuenden Spiegelflächenelement (28) und einen Zwischenfokus (23) bezeichnet, in den der EUV-Kollektor (16) einen Quellbereich (15) überführt,
   - wobei dIF einen zulässigen Durchmesser des Zwischenfokus (23) bezeichnet.

7. Verfahren zur Herstellung eines EUV-Kollektors (16) nach einem der Ansprüche 1 bis 6 mit folgenden Schritten:

   - Bereitstellen eines Roh-Kollektorsubstrats, welches über alle Ortswellenlängen eine Ausgangsrauheit (25) aufweist,
   - Bearbeiten einer Oberfläche des Roh-Kollektorsubstrats so, dass eine effektive Rauheit ($\mathrm{rms_G}$) nur unterhalb der Grenz-Ortswellenlänge ($P_G$) um mehr als einen Faktor 1,5 reduziert wird.

8. Verfahren nach Anspruch 7, **dadurch gekennzeichnet, dass** das Oberflächenbearbeiten des Roh-Kollektorsubstrats einen Polierschritt beinhaltet.

9. Beleuchtungssystem

   - mit einem EUV-Kollektor (16) nach einem der Ansprüche 1 bis 6,
   - mit einer Beleuchtungsoptik (6) zur Führung des Beleuchtungslichts (3) vom EUV-Kollektor (16) hin zu einem Objektfeld (4) in einer Objektebene (5), in dem ein abzubildendes Objekt (10) anordenbar ist.

10. Beleuchtungssystem nach Anspruch 9, **dadurch**

**gekennzeichnet, dass** der EUV-Kollektor (16) feldnah in Bezug auf eine zur Objektebene (5) konjugierte Feldebene angeordnet ist.

11. Beleuchtungssystem nach Anspruch 9 oder 10, **gekennzeichnet durch** eine Projektionsoptik (7) zur Abbildung des Objektfeldes (4) in ein Bildfeld (8), in dem ein Substrat (11) anordenbar ist.

12. Projektionsbelichtungsanlage (1) mit einem Beleuchtungssystem nach Anspruch 11 und mit einer EUV-Lichtquelle (2).

13. Verfahren zur Herstellung eines strukturierten Bauteils mit folgenden Verfahrensschritten:

- Bereitstellen eines Retikels (10) und eines Wafers (11),
- Projizieren einer Struktur auf dem Retikel (10) auf eine lichtempfindliche Schicht des Wafers (11) mithilfe der Projektionsbelichtungsanlage nach Anspruch 12,
- Erzeugen einer Mikro- bzw. Nanostruktur auf dem Wafer (11).

**Claims**

1. EUV collector (16) for use in an EUV projection exposure apparatus (1),

- comprising at least one mirror surface (20), which has surface structures (24) for scattering a used EUV wavelength ($\lambda$) of used EUV light (3),
- wherein the mirror surface (20) has a surface height with a spatial wavelength distribution (26; 34; 35) between a lower limit spatial wavelength ($P_G$) and an upper limit spatial wavelength ($P_{G'}$),
- wherein the lower limit spatial wavelength ($P_G$) lies in the range between 1 $\mu$m and 100 $\mu$m,
- wherein the upper limit spatial wavelength ($P_{G'}$) is at least ten times as large as the lower limit spatial wavelength ($P_G$),
- wherein an effective roughness ($rms_G$) below the lower limit spatial wavelength ($P_G$) satisfies the following relation:

$$(4 \pi \, rms_G \, \cos(\theta)/\lambda)^2 < 0.1$$

- where $\theta$ denotes an angle of incidence of the used EUV light (3) at the mirror surface (20),
- wherein the following applies to an effective roughness ($rms_{GG'}$) between the lower limit spatial wavelength ($P_G$) and the upper limit spatial wavelength ($P_{G'}$):

$$1.5 \, rms_G < rms_{GG'} < 6 \, rms_G,$$

**characterized in that** the collector (16) has a mirror centre (31), wherein the spatial wavelength distribution (26; 34; 35) is such that a mirror surface element (28) has a radial scattering angle distribution (33r) in relation to the mirror centre (31) that deviates from an azimuthal scattering angle distribution (33a) in relation to the mirror centre (31).

2. EUV collector according to Claim 1, **characterized in that** the limit spatial wavelength ($P_G$) is greater than 5 $\mu$m.

3. EUV collector according to Claim 1 or 2, **characterized in that** the radial scattering angle distribution (33r) covers a greater scattering angle range than the azimuthal scattering angle distribution (33a).

4. EUV collector according to Claim 1 or 2, **characterized in that** the azimuthal scattering angle distribution covers a greater scattering angle range than the radial scattering angle distribution.

5. EUV collector according to any one of Claims 1 to 4, **characterized in that** at least one portion of the mirror surface (20) has a grating structure (21) for diffracting extraneous light (19), the wavelength of which deviates from the used EUV wavelength.

6. EUV collector (16) for use in an EUV projection exposure apparatus (1),

- comprising at least one mirror surface (20), which has surface structures (24) for scattering a used EUV wavelength ($\lambda$) of used EUV light (3),
- wherein the mirror surface (20) has a surface height with a spatial wavelength distribution (26; 34; 35) between a lower limit spatial wavelength ($P_G$) and an upper limit spatial wavelength ($P_{G'}$),
- wherein the lower limit spatial wavelength ($P_G$) lies in the range between 1 $\mu$m and 100 $\mu$m,
- wherein the upper limit spatial wavelength ($P_{G'}$) is at least ten times as large as the lower limit spatial wavelength ($P_G$),
- wherein an effective roughness ($rms_G$) below the lower limit spatial wavelength ($P_G$) satisfies the following relation:

$$(4 \pi \, rms_G \, \cos(\theta)/\lambda)^2 < 0.1$$

- where $\theta$ denotes an angle of incidence of the used EUV light (3) at the mirror surface (20),
- wherein the following applies to an effective roughness ($rms_{GG'}$) between the lower limit spatial wavelength ($P_G$) and the upper limit spatial wavelength ($P_{G'}$):

$$1.5 rms_G < rms_{GG'} < 6 rms_G,$$

**characterized in that** the following condition applies to the lower limit spatial wavelength ($P_G$) of the spatial wavelength distribution of the surface height:

$$P_G \approx (2L/dIF) \; \lambda \; 1/\cos(\theta),$$

- where L denotes a distance between a scattering mirror surface element (28) which has the surface structures and an intermediate focus (23), into which the EUV collector (16) transmits a source region (15),
- where dIF denotes an admissible diameter of the intermediate focus (23).

**7.** Method for producing an EUV collector (16) according to any one of Claims 1 to 6, including the following steps:

- providing a raw collector substrate, which has an initial roughness (25) over all spatial wavelengths,
- processing a surface of the raw collector substrate such that an effective roughness ($rms_G$) is reduced only below the limit spatial wavelength ($P_G$) by more than a factor of 1.5.

**8.** Method according to Claim 7, **characterized in that** the processing of the surface of the raw collector substrate comprises a polishing step.

**9.** Illumination system

- comprising an EUV collector (16) according to any one of Claims 1 to 6,
- comprising an illumination optical unit (6) for guiding the illumination light (3) from the EUV collector (16) towards an object field (4) in an object plane (5), in which an object (10) to be imaged is arrangeable.

**10.** Illumination system according to Claim 9, **characterized in that** the EUV collector (16) is arranged in near-field fashion in relation to a field plane that is conjugate to the object plane (5).

**11.** Illumination system according to Claim 9 or 10, **characterized by** a projection optical unit (7) for imaging the object field (4) into an image field (8), in which a substrate (11) is arrangeable.

**12.** Projection exposure apparatus (1) comprising an illumination system according to Claim 11 and comprising an EUV light source (2).

**13.** Method for producing a structured component, including the following method steps:

- providing a reticle (10) and a wafer (11),
- projecting a structure on the reticle (10) onto a light-sensitive layer of the wafer (11) with the aid of the projection exposure apparatus according to Claim 12,
- producing a microstructure and/or nanostructure on the wafer (11).

**Revendications**

**1.** Collecteur EUV (16) pour la mise en œuvre dans une installation d'exposition par projection EUV (1),

- comprenant au moins une surface de miroir (20) qui présente des structures superficielles (24) pour disperser une longueur d'onde utile EUV (λ) d'une lumière utile EUV (3),
- la surface de miroir (20) présentant une hauteur de surface ayant une répartition spatiale en longueur d'onde (26 ; 34 ; 35) entre une longueur d'onde spatiale de limite inférieure ($P_G$) et une longueur d'onde spatiale de limite supérieure ($P_{G'}$),
- la longueur d'onde spatiale de limite inférieure ($P_G$) étant située dans la plage entre 1 μm et 100 μm,
- la longueur d'onde spatiale de limite supérieure ($P_{G'}$) étant au moins dix fois supérieure à l'onde spatiale de limite inférieure ($P_G$),
- une rugosité effective ($rms_G$) au-dessous de la longueur d'onde spatiale de limite inférieure ($P_G$) satisfaisant à la relation suivante :

$$(4 \, \pi \, rms_G \, \cos(\theta)/\lambda)^2 < 0,1$$

- où θ désigne un angle d'incidence de la lumière utile EUV (3) sur la surface de miroir (20),
- dans lequel, pour une rugosité effective ($rms_{GG'}$) entre la longueur d'onde spatiale de limite inférieure ($P_G$) et la longueur d'onde spatiale de limite supérieure ($P_{G'}$) soit :

$$1,5 \, rms_G < rms_{GG'} < 6 \, rms_G,$$

**caractérisé en ce que** le collecteur (16) présente un centre de miroir (31), la répartition spatiale en longueur d'onde (26 ; 34 ; 35) étant telle qu'un élément de surface de miroir (28) présente une répartition d'angles de dispersion (33r) radiale par rapport au centre de miroir et qui est différente d'une répartition d'angles de dispersion (33a) azimutale par rapport au centre de miroir (31).

2. Collecteur EUV selon la revendication 1, **caractérisé en ce que** la longueur d'onde spatiale de limite (P$_G$) est supérieure à 5 µm.

3. Collecteur EUV selon la revendication 1 ou 2, **caractérisé en ce que** la répartition d'angles de dispersion radiale (33r) couvre une plage d'angles de dispersion supérieure à la répartition d'angles de dispersion azimutale (33a).

4. Collecteur EUV selon la revendication 1 ou 2, **caractérisé en ce que** la répartition d'angles de dispersion azimutale couvre une plus grande plage d'angles de dispersion que la répartition d'angles de dispersion radiale.

5. Collecteur EUV selon l'une quelconque des revendications 1 à 4, **caractérisé en ce qu'**une partie de la surface de miroir (20) présente une structure de grille (21) pour diffracter de la lumière parasite (19) dont la longueur d'onde est différente de la longueur d'onde utile EUV.

6. Collecteur EUV (16) pour la mise en œuvre dans une installation d'exposition par projection EUV (1),

- comprenant au moins une surface de miroir (20) qui présente des structures superficielles (24) pour disperser une longueur d'onde utile EUV (λ) d'une lumière utile EUV (3),
- la surface de miroir (20) présentant une hauteur de surface ayant une répartition spatiale en longueur d'onde (26 ; 34 ; 35) entre une longueur d'onde spatiale de limite inférieure (P$_G$) et une longueur d'onde spatiale de limite supérieure (P$_{G'}$),
- la longueur d'onde spatiale de limite inférieure (P$_G$) étant située dans la plage entre 1 µm et 100 µm,
- la longueur d'onde spatiale de limite supérieure (P$_{G'}$) étant au moins dix fois supérieure à l'onde spatiale de limite inférieure (P$_G$),
- une rugosité effective (rms$_G$) au-dessous de la longueur d'onde spatiale de limite inférieure (P$_G$) satisfaisant à la relation suivante :

$$(4 \; \pi \; \text{rms}_G \; \cos(\theta)/\lambda)^2 \; < \; 0,1$$

- où θ désigne un angle d'incidence de la lumière utile EUV (3) sur la surface de miroir (20),
- dans lequel, pour une rugosité effective (rms$_{GG'}$) entre la longueur d'onde spatiale de limite inférieure (P$_G$) et la longueur d'onde spatiale de limite supérieure (P$_{G'}$) soit :

$$1,5 \; \text{rms}_G \; < \; \text{rms}_{GG'} \; < \; 6 \; \text{rms}_G,$$

**caractérisé en ce que** pour la longueur d'onde spatiale de limite inférieure (P$_G$) de la répartition spatiale en longueur d'onde de la hauteur de surface, la condition suivante s'applique :

$$PG \; \approx \; (2L/dIF) \; \lambda \; 1/\cos\theta$$

- où L désigne une distance entre un élément de surface de miroir dispersif (28) présentant les structures superficielles et un foyer intermédiaire (23) auquel le collecteur EUV (16) transfère une zone source (15),
- où dIF désigne un diamètre admissible du foyer intermédiaire (23).

7. Procédé de fabrication d'un collecteur EUV (16) selon l'une quelconque des revendications 1 à 6, comprenant les étapes suivantes consistant à :

- fournir un substrat de collecteur brut qui présente une rugosité initiale (25) sur toutes les longueurs d'onde spatiales,
- traiter une surface du substrat de collecteur brut de telle sorte qu'une rugosité effective (rms$_G$) n'est réduite de plus d'un facteur 1,5 qu'au-dessous de la longueur d'onde spatiale de limite (P$_G$).

8. Procédé selon la revendication 7, **caractérisé en ce que** le traitement de surface du substrat de collecteur brut comprend une étape de polissage.

9. Système d'éclairage

- comprenant un collecteur EUV (16) selon l'une quelconque des revendications 1 à 6,
- comprenant une optique d'éclairage (6) pour guider la lumière d'éclairage (3) du collecteur EUV (16) jusqu'à un champ d'objet (4) dans un plan d'objet (5) dans lequel un objet (10) à imager peut être disposé.

10. Système d'éclairage selon la revendication 9, **caractérisé en ce que** le collecteur EUV (16) est disposé proche du champ par rapport à un plan de champ conjugué au plan d'objet (5).

11. Système d'éclairage selon la revendication 9 ou 10, **caractérisé par** une optique de projection (7) pour imager le champ d'objet (4) dans un champ d'image (8) dans lequel un substrat (11) peut être disposé.

12. Installation d'exposition par projection (1) comprenant un système d'éclairage selon la revendication 11 et une source de lumière EUV (2).

13. Procédé de fabrication d'un composant structuré, comprenant les étapes de procédé suivantes consistant à:

    - fournir un réticule (10) et une plaquette (11),
    - projeter une structure sur le réticule (10) sur une couche photosensible de la plaquette (11) à l'aide de l'installation d'exposition par projection selon la revendication 12,
    - générer une microstructure ou une nanostructure sur la plaquette (11).

Fig. 1

Fig. 2

Fig. 3

Fig. 4

Fig. 5

Fig. 6

Fig. 7

Fig. 8

Fig. 9

Fig. 10

Fig. 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102013002064 A1
- DE 102009044462 A1
- DE 102006022352 A1
- EP 1796147 A1
- DE 102012209882 A1
- WO 2013174644 A1
- WO 2009024164 A
- DE 102009045096 A1
- DE 102012202675 A1

**In der Beschreibung aufgeführte Nicht-Patentliteratur**

- Cooled EUV collector optics for LPP and DPP sources. **X. BOZEC et al.** EXTREME ULTRAVIOLET (EUV) LITHOGRAPHY II. SPIE, 17. Marz 2011, vol. 7969, 1-10
- **L. GIRARD et al.** Fabrication of EUVL microfield exposure tools with 0.5 NA. *OPTOMECHATRONIC MICRO/NANO DEVICES AND COMPONENTS III,* 08. Oktober 2017
- PROCEEDINGS OF SPIE. SPIE, 11. Oktober 2015, vol. 9633, 96330V-96330V
- **JOHN C. STOVER.** Optical Scattering: Measurement and Analysis. SPIE, 1995
- **DUPARRE et al.** *Applied Optics,* 01. Januar 2002, vol. 41 (1